# EUROPEAN PATENT APPLICATION

(11) **EP 0 604 772 A1**
(43) Date of publication of application: **06.07.1994**
(21) Application number: 93119158.9
(22) Date of filing: 27.11.1993
(51) Int. Cl.: H03H 17/06

(54) **Method and device for discrete-time signal interpolation**

(30) Priority: 30.12.1992 ES 9202651
(71) Applicant: ALCATEL STANDARD ELECTRICA, S.A., E-28045 Madrid (ES); ALCATEL N.V., NL-1077 XX Amsterdam (NL)
(72) Inventor: Fernandez Duran, Alfonso, E-28692 Villanueva de la Canada (Madrid) (ES); Perez Abadia, Mariano, E-28045 Madrid (ES); Gonzalez Ahijado, Angel, E-28916 Leganes (Madrid) (ES)
(74) Representative: Pohl, Herbert, Dipl.-Ing

(57) **Abstract**

Of particular application in digital processing systems that require oversampling.

As a first step in the method a derivative of generic order "n" of the input signal to be interpolated is taken; subsequently the interpolation process itself takes place on the samples of the n-th derivative of the signal, and finally integration of the previously interpolated signal, to the same order "n" as the derivative is done.

The device implements the method described.

## Description

### OBJECT OF THE INVENTION

This invention, as stated in the title, refers to a method and a device for the discrete-time signal interpolation in order to obtain a sampling rate greater than the original, that substancially improves the quality of digital interpolators, for a given complexity.

### BACKGROUND TO THE INVENTION

There are many interpolation methods that make use of mathematical analyses and which are based either on digital analysis or on digital filtering in order to obtain the values of the interpolated samples between every two consecutive initial samples.

Among the digital analysis methods, mention can be made of those of Newton and Lagrange, which calculate the interpolated intermediate samples by means of polynomials having their name, of different orders. The coefficients of these polynomials are obtained by means of arithmetical operations on the samples of the original signal, such that the greater the order of the polynomial is, the more accurate the value of the interpolated samples is, although, for this, it is necessary to carry out a greater number of mathematical operations and, as a result, the complexity is also greater.

The digital filtering methods are based on locating samples of null value between every two consecutive samples of the original signal and then performing a lowpass digital filtering that removes the undesired frequencies that appear as a result of the previous operation. Also in these methods, the complexity of the digital filter depends on the accuracy required for the interpolated samples and, just as before, the greater the required precision is, the more complex the filter is, and more mathematical operations are required to carry out the filtering.

The main drawback of these methods is that when good accuracy is required, the number of mathematical operations is so great that the power consumed at high frequencies becomes unacceptable.

### TECHNICAL PROBLEM TO BE OVERCOME

Consequently the technical problem to be overcome consists in reducing the number of mathematical operations required to perform the interpolation, for a given accuracy, and consequently to reduce the high frequency power consumption.

### CHARACTERIZATION OF THE INVENTION

This invention provides a method for interpolation and a device to perform this method which, for the same accuracy, makes use of a lower number of mathematical operations than the methods mentioned above and, as a result, the power consumption of the device that performs the method is also lower.

The method mentioned is based on the use of any of the interpolation methods already known with reduced complexity, which means a lower number of mathematical operations but also less accuracy, and in that its application is not done over the original signal to be interpolated but over its mathematical derivative of generic order "n", subsequently proceeding to the integration of the signal attained at the output of the interpolator employed, by means of an integrator of the same order "n" as the previous derivator.

With the application of this method, the complexity (understood as the number of mathematical operations necessary to develop this method) becomes less and the power consumption of the device that also implements this method is, consequently, much less.

In addition, it has been found in experimental results that, for a very simple interpolation model with poor features, such as repeating the last sample, the improvement resulting from applying this method is up to 10 dB per order of derivative, depending on the type of signal (bandwidth, minimum frequency, etc.).

### BRIEF FOOTNOTES TO THE FIGURES

A more detailed explanation of the invention is given in the following description based in the accompanying figures, in which:
- figure 1 is a flowchart of the method in accordance with the invention,
- figure 2 is a general block diagram of the device of the invention,
- figure 3 shows a more detailed block diagram of an n-th order derivator and its composition, and
- figure 4 shows a more detailed block diagram of an n-th order integrator and its composition.

### DESCRIPTION OF THE INVENTION

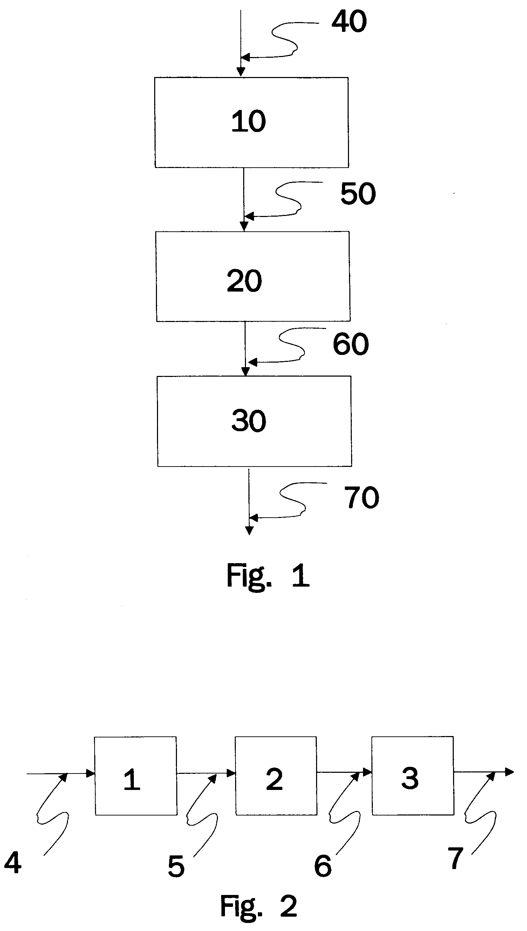

The flowchart of figure 1 shows the steps that form the method in accordance with the invention. In this case, the discrete-time signal to be interpolated 40 is applied to a first stage for obtaining the n-th order derivative 10 generating an output signal 50. This signal is applied to a second interpolation stage 20, as occurs normally, to attain the output signal 60 that is applied to a third stage that performs the n-th order integration 30.

After this final stage, the signal obtained 70 is a sampled signal with a sampling rate greater than the initial one.

The block diagram of figure 2 represents the basic blocks of the device that implements the invention. To this end, it is made use of a digital interpolation filter 2, of the type already known, that produces an interpolated signal whose sampling frequency at its output is greater than the sampling frequency of the input signal.

The interpolated signal obtained in this way, has an interpolation error (also termed interpolation noise) that depends on the interpolation algorithm used and which is located at the frequencies that are multiples of the sampling frequency prior to interpolation and which simultaneously do not correspond to frequencies that are multiples of the new sampling frequency after the digital interpolation filter 2.

To reduce this interpolation noise, in accordance with the invention, it is made use of an n-th order derivator 1 before the digital interpolation filter 2, whereby the amplitude of the signal is increased with the frequency.

At the output of the digital interpolation filter 2, an interpolated signal 6 is obtained with a greater sampling rate and with a given interpolation noise. This interpolated signal 6 is applied to an n-th order integrator 3 that compensates the earlier increment in the amplitude with frequency and which, at the same time, reduces the interpolation noise so that it is possible to have the same interpolation quality with a simple interpolation filter used according to this invention, as with a more complex interpolation filter.

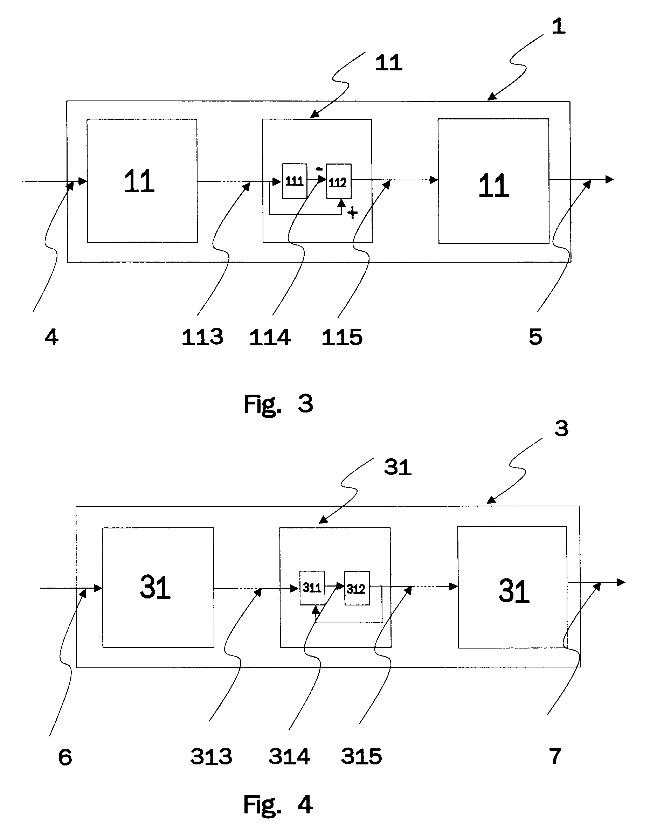

Figure 3 shows the composition of the n-th order derivator 1 as a set of "n" elementary derivation devices 11 for obtaining the first order derivative, which are connected in cascade. Because of the digital nature of the signal to be interpolated, the implementation of each elementary derivation device 11 for obtaining the first order derivative is based on a circuit formed by delaying means 111 to delay the signal at their input 113 and subtracting means 112 to subtract the delayed signal 114, obtained by these delaying means, from the input signal to this device, and so obtaining an output signal 115 that is the first order derivative of the input signal 113.

The complexity added by each elementary derivation device 11 is very small because only a few elementary operations are required.

In the same way, figure 4 shows the composition of the n-th order integrator 3 as a set of "n" elementary integration devices 31 for obtaining the first order integral, that are connected in cascade. The implementation of each of these first order integration devices 31 for obtaining the first order integral, because of the digital nature of this signal, is done by an accumulator formed by adding means 311 to perform the sum of the input signal 313 with the output signal 315 of this elementary integration device 31 in order to obtain the first order integral. The output 314 from these adding means 311 is delayed in delaying means 312 that produce the output signal 315.

In the same way as before, the complexity added in this method for calculating the first order integral is very low.

As a consequence, all additional complexity due to the n elementary derivation devices 11 and to the n elementary integration devices 31 is very low considering the advantages obtained in terms of reducing the interpolation noise.

## Claims

1. **METHOD FOR DISCRETE-TIME SIGNAL INTERPOLATION characterized** in that it consists of the following steps:
- obtaining the n-th order derivative (10) of the signal to be interpolated,
- interpolation (20) of new samples between every two consecutive samples already existing, by means of the use of any known interpolation method, and
- obtaining the n-th order integral (30) of the previously interpolated signal.

2. **DEVICE FOR DISCRETE-TIME SIGNAL INTERPOLATION characterized** in that it includes:
- an n-th order derivator (1) of the digital signal to be interpolated (4),
- a digital interpolation filter (2), that generates digital samples of the signal at its input (5) at a greater sampling frequency with an interpolation error depending on the type of interpolator, that is connected to the previous n-th order derivator (1), and
- an n-th order integrator (3) of the signal at its input (6), that is connected to the output of the digital interpolation filter (2);
all this in order to obtain an interpolated signal (7) of the input signal (4) at the output to this device.

3. **DEVICE** in accordance with claim 2, **characterized:**
- in that the n-th order derivator (1) is formed by the cascaded connection of "n" elementary derivation devices (11) each of which produces a first order derivative; and
- in that each of the elementary derivation devices (11) is formed by delaying means (111), in order to delay the signal at its input (113) and obtain a delayed signal (114), connected to subtracting means (112) in order to subtract this delayed signal (114) from the input signal (113); obtaining in this way the output signal (115) of this elementary derivation device (11).

4. **DEVICE** according to claim 2, **characterized:**
- in that the n-th order integrator (3) is formed by the connection in cascade of "n" elementary integration devices (31) each producing the first order integral, and
- in that each of the elementary integration devices (31) is formed by adding means (311) in order to obtain the sum (314) of the input signal (313) and the output signal (315) of this elementary integration device (31), and delaying means (312), connected to the previous adding means (311), in order to obtain the output signal (315) of this elementary integration device (31) which is a delayed signal of the sum (314) obtained at the output of the adding means (311).
